# EUROPÄISCHE PATENTSCHRIFT

(11) **EP 0 725 986 B1**
(45) Veröffentlichungstag und Bekanntmachung des Hinweises auf die Patenterteilung: **04.06.1997**
(21) Anmeldenummer: 94926103.6
(22) Anmeldetag: 06.09.1994
(51) Int. Cl.: H01R 13/633, H01R 23/72, H01R 23/70, H05K 7/14

(54) **ELEKTRISCHE BAUGRUPPE**
ELECTRICAL UNIT
APPAREIL ELECTRIQUE

(30) Priorität: 25.10.1993 DE 4336786
(43) Veröffentlichungstag der Anmeldung: 14.08.1996
(73) Patentinhaber: SIEMENS AKTIENGESELLSCHAFT, 80333 München (DE)
(72) Erfinder: BRUCH, Helmut, D-13581 Berlin (DE); KNEIER, Michael, D-13407 Berlin (DE); SCHRÖDINGER, Karl, D-14089 Berlin (DE); SCHULZ, Klaus,Dr., D-12309 Berlin (DE)
(86) Internationale Anmeldenummer: DE9401082
(87) Internationale Veröffentlichungsnummer: WO9512227

(56) Entgegenhaltungen:
- GB-A- 2 115 239
- US-A- 3 944 311
- US-A- 4 480 885
- US-A- 4 750 091

## Beschreibung

Die Erfindung betrifft eine elektrische Baugruppe mit einer Leiterplatte mit einem mehrpoligen Steckverbinder, der mit einem korrespondierenden Steckverbinder einer Hauptplatine verbindbar ist, und mit einem Demontagehebel mit mindestens einer Druckfläche, der aus einer Verbindungsstellung in eine Demontagestellung verschwenkbar ist, in der sich die Druckfläche gegen die Hauptplatine abstützt und eine die Steckverbindung lösende Kraft erzeugt.

In der Elektrotechnik, z. B. in der optischen Übertragungstechnik, besteht die Aufgabe, elektrische Baugruppen mit einer Leiterplatte und mit einem mehrpoligen Steckverbinder elektrisch und mechanisch zuverlässig mit einer Hauptplatine zu verbinden. Es ist grundsätzlich bekannt, die elektrische Verbindung mittels korrespondierender Steckverbinder zu schaffen.

Eine elektrische Baugruppe der eingangs genannten Art ist aus der US-PS 4,480,885 bekannt. Bei dieser Baugruppe ist zwischen einer Leiterplatte und einem Steckverbinder ein von Kontaktstiften durchdrungenes Abstandsteil angeordnet. An beiden Schmalseiten des Abstandsteils sind Demontagehebel verschwenkbar gelagert, die beim Verschwenken auf die korrespondierende Hauptplatine verbindungslösende Druckkräfte ausüben.

Aus der DE-C2-32 43 309 ist zur mechanischen Verbindung einer Aufnahme für einen optischen Steckerstift mit einer Hauptplatine die Verwendung von Rastfingern mit endseitigen Rastelementen bekannt. Die Rastelemente werden unter elastischer Verformung der Rastfinger durch entsprechende Öffnungen der Hauptplatine geschoben, die derart bemessen sind, daß die Rastelemente im verbundenen Zustand an der Hauptplatine fixierend verrasten.

Die US-PS 4,750,091 betrifft die spielfreie mechanische Befestigung einer Leiterplatte, insbesondere in Gerätegehäusen mit einem frontseitigen Bedienungsfeld mit Druckschaltern zur Betätigung auf der Leiterplatte angeordneter elektrischer Schalter. Dazu ist eine unmittelbare Verriegelung der Leiterplatte an einem umlaufenden Rahmen des Bedienfeldes vorgesehen, wobei die elektrische Verbindung der Leiterplatte zu einer Hauptplatine über eine separate Buchse und ein flexibles Kabel erfolgt. Die Problematik einer ggf. notwendigen Demontage ist nicht angesprochen.

Die WO 93/18559 offenbart eine elektrische und mechanische Verbindung einer Leiterplatte eines elektrischen Moduls mit einer Hauptplatine, wobei die Leiterplatte in einen separaten auf der Hauptplatine fixierten Sockel eingeführt und senkrecht zur Hauptplatine gehalten wird. Zur Fixierung des Moduls verrasten modulseitig angeordnete Rastelemente in korrespondierenden Rastaufnahmen des separaten Sockels. Die elektrischen Verbindungen werden durch auf Kontaktflächen der Leiterplatte federnd aufliegende Einzelkontakte hergestellt, so daß zum Lösen der elektrischen Verbindung kaum Zugkräfte aufgewendet werden müssen.

Aus dem deutschen Gebrauchsmuster DE-U1-91 14 294.6 ist eine steckbare Anschlußeinheit bekannt, an deren einer Seite elektrische Anschlußleitungen angeordnet sind und an deren gegenüberliegender Seite ein Auswerferhebel schwenkbar gelagert ist. Beim Verschwenken des Hebels stützt sich eine nockenartig ausgebildete Fläche des Hebels z. B. an einer Flachbaugruppe (Hauptplatine) ab und löst dadurch eine zwischen der Einheit und der Flachbaugruppe bestehende Steckverbindung. Eine in jedem Betriebsfall sichere Befestigung der Einheit, insbesondere bei Anordnung an der Flachbaugruppenunterseite, ist nicht gewährleistet.

Zur elektrischen und mechanischen Verbindung einer Leiterplatte, die stirnkantenseitig eine Kontaktleiste aufweist, mit einer Hauptplatine ist aus der DE-C2-22 21 995 eine Vorrichtung mit an der Hauptplatine oder an einem Apparategestell angebrachten Führungen bekannt, an denen Hebel drehbar gelagert sind. Die Hebel weisen jeweils einen Schlitz auf, mit dem jeweils ein auf der Leiterplatte befestigter Bolzen in Eingriff bringbar ist, so daß die Leiterplatte durch die Hebelbewegung senkrecht zur Hauptplatine unter Bildung oder Lösung der elektrischen Verbindung bewegt werden können. Zur Bewegung der Hebel ist ein erheblicher Freiraum seitlich neben der Leiterplatte erforderlich.

Die GB-A-2 115 239 offenbart eine elektrische und mechanische Verbindung einer hybriden Leiterplatte mit an zumindest zwei Seitenkanten angeordneten Kontaktflecken mit einer Hauptplatine. Dazu wird die Leiterplatte in einen Rahmen eingesetzt, dessen Seitenwände innenseitig mit federnden und mit den Kontaktflecken korrespondierenden Kontaktfahnen versehen sind. An dem fest mit der Hauptplatine verbundenem Rahmen ist zumindest ein schwenkbarer Hebel gelagert. Zum Einsetzen oder Entnehmen der Leiterplatte aus dem Rahmen wird der Hebel verschwenkt, wobei die vom Hebel ausgeübten Kräfte unter Biegebelastung der Leiterplatte nur im Kantenbereich und unmittelbar auf die Leiterplatte einwirken.

Bei der Demontage einer Baugruppe mit einem mehrpoligen Steckverbinder müssen zum Lösen Zugkräfte aufgewendet werden, die bei einem vielpoligen Steckverbinder durchaus im Bereich von 100 N liegen und hinsichtlich der Krafteinleitung eine erhebliche (Biege-) Belastung der Baugruppe darstellen können. Die von dem Steckverbinder erzeugten relativ hohem mechanischen Verbindungskräfte sind nur lokal im Bereich der Steckverbindung wirksam. Die übrigen Bereiche der Baugruppe sind dagegen bei äußeren mechanischen Belastungen womöglich unzureichend fixiert. Insbesondere bei sehr dichter Anordnung und bei beidseitiger Anordnung von Baugruppen an der Hauptplatine ist eine beschädigungsfreie Demontage beispielsweise zu Service- oder Reparaturzwecken problematisch.

Die Aufgabe der Erfindung besteht daher in der Schaffung einer elektrischen Baugruppe, die in einfacher Weise mit einer Hauptplatine elektrisch und mechanisch zuverlässig verbindbar ist und die bei einfachem konstruktiven Aufbau vergleichsweise leicht von der Hauptplatine demontierbar ist.

Diese Aufgabe wird bei einer Baugruppe der eingangs beschriebenen Art erfindungsgemäß dadurch gelöst, daß die Leiterplatte in einen Rahmen eingesetzt ist, der an gegenüberliegenden Seiten Rastfinger mit Rastelementen aufweist, wobei die Rastfinger beim Verbinden der Steckverbinder von Körperkanten der Hauptplatine elastisch verformbar sind und wobei die Rastelemente im verbundenen Zustand an der Hauptplatine fixierend verrasten, und daß der Demontagehebel an dem Rahmen gelagert ist.

Die von dem Demontagehebel erzeugten Abdruckkräfte können so groß bemessen sein, daß gleichzeitig mit dem Lösen der Steckverbindung auch die Rastfinger elastisch verformt und außer Eingriff mit den Körperkanten gebracht werden. Dazu können die Rastelemente an ihren Konktaktzonen mit der Hauptplatine schräge Flächen aufweisen, die bei bestimmten Abdruckkräften das Entrasten ermöglichen. Ergänzend oder alternativ können den Rastfingern Betatigungsflachen zugeordnet sein, auf die manuell und/oder durch einen Fortsatz des Demontagehebels in der Demontagestellung die Rastelemente entrastende Kräfte aufbringbar sind.

Ein wesentlicher Vorteil der erfindungsgemäßen Baugruppe besteht darin, daß neben den zur Gewährleistung einer sicheren mechanischen und elektrischen Verbindung notwendigen Elemente (nämlich des Steckverbinders und der Rastfinger) auch der zum Entrasten und zum Abdrücken der Baugruppe von der Hauptplatine vorgesehene Demontagehebel ein mit der Baugruppe verbundener und somit stets einsatzbereiter Bestandteil ist. Die mechanische Verbindung der erfindungsgemäßen, demontierbaren Baugruppe mit der Hauptplatine ist ohne zusätzliche Schrauben, Muttern oder Abstandsbuchsen möglich, so daß im demontierten Zustand keine einzeln zu handhabenden Befestigungsteile frei werden. Bei Verwendung von zwei Rastfingern mit zugeordneten Betatigungsflächen kann eine Person zum Entrasten der Rastelemente mit den Fingern einer Hand auf die beiden Betatigungsflachen drücken. Damit wird eine im Hinblick auf die Materialbeanspruchung besonders vorteilhafte, gezielte und genau bestimmbare Bewegung der Rastfinger gewährleistet. Mit der anderen Hand kann der Demontagehebel in die Demontagestellung verschwenkt werden. Diese Schwenkbewegung erzeugt eine senkrecht zur Hauptplatine wirkende Trennungskraft, indem sich die Druckfläche(n) des Demontagehebels unmittelbar auf der Hauptplatine oder auf einer speziell ausgebildeten Anlagefläche der Hauptplatine abstützen kann. Dadurch wird die elektrische Baugruppe beim Trennungsvorgang insgesamt vergleichsweise gering mechanisch belastet. Die erfindungsgemäße Baugruppe erfordert zur Demontage kaum einen seitlichen Zugangs raum, so daß mehrere Baugruppen sowohl vergleichsweise dicht nebeneinander als auch übereinander gegenüberliegend auf der Hauptplatine angeordnet werden können (hohe Packungsdichte).

Eine bei manueller Krafteinwirkung auf die Betätigungsflächen besonders vorteilhafte Ausbildung der Erfindung besteht darin, daß die Rastfinger Entriegelungshebel aufweisen, die sich von den Rahmen-Längsseiten aus und von der Leiterplatte weg erstrecken und deren nach außen gerichtete Flächen die Betätigungsflächen sind. Zur weiteren Erhöhung der lateralen Packungsdichte können die Betatigungsflachen jeweils nach innen gekröpft sein.

Um die Entriegelungshebel in fertigungstechnisch bevorzugter Weise als Kunststoff-Spritzgußteile einfach ausführen zu können und um Handhabungsfehler bei der Demontage zu vermeiden, sind die Entriegelungshebel im wesentlichen als gerade dreiseitige Prismen ausgebildet, deren jeweils seitlich nach außen weisende Seite die Betätigungsfläche bildet, wobei der Abstand zwischen der jeweils der Leiterplatte zugewandten Seite und der Leiterplatte gemäß der gewünschten maximalen Auslenkung der Rastfinger bemessen ist.

Eine besonders handhabungsfreundliche Ausgestaltung der erfindungsgemäßen Baugruppe sieht vor, daß der Demontagehebel an den Rahmen-Längsseiten gelagert ist und einen sich im wesentlichen zwischen den Längsseiten erstreckenden Bügel enthält.

Eine fertigungstechnisch bevorzugte Weiterbildung der Erfindung, nach der der Rahmen als einstückiges Kunststoffspritzteil ausgebildet sein kann, sieht vor, daß die Rastfinger einstückig mit der jeweiligen Rahmen-Längsseite ausgebildet sind und daß der Querschnitt der Rahmen-Längsseite beidseitig des Rastfingers vermindert ist.

Um jeweils zwei elektrische Baugruppen annähernd deckungsgleich beidseitig der Hauptplatine anordnen zu können, ist bevorzugt eine gegeneinander versetzte Anordnung der an gegenüberliegenden Rahmen-Längsseiten ausgebildeten Rastfinger vorgesehen.

Ein Ausführungsbeispiel der Erfindung wird nachfolgend anhand einer Zeichnung weiter erläutert; es zeigen:
Figur 1 eine erfindungsgemäße elektrische Baugruppe in Explosionsdarstellung und
Figur 2 die Baugruppe im Verbindungszustand mit einer Hauptplatine.

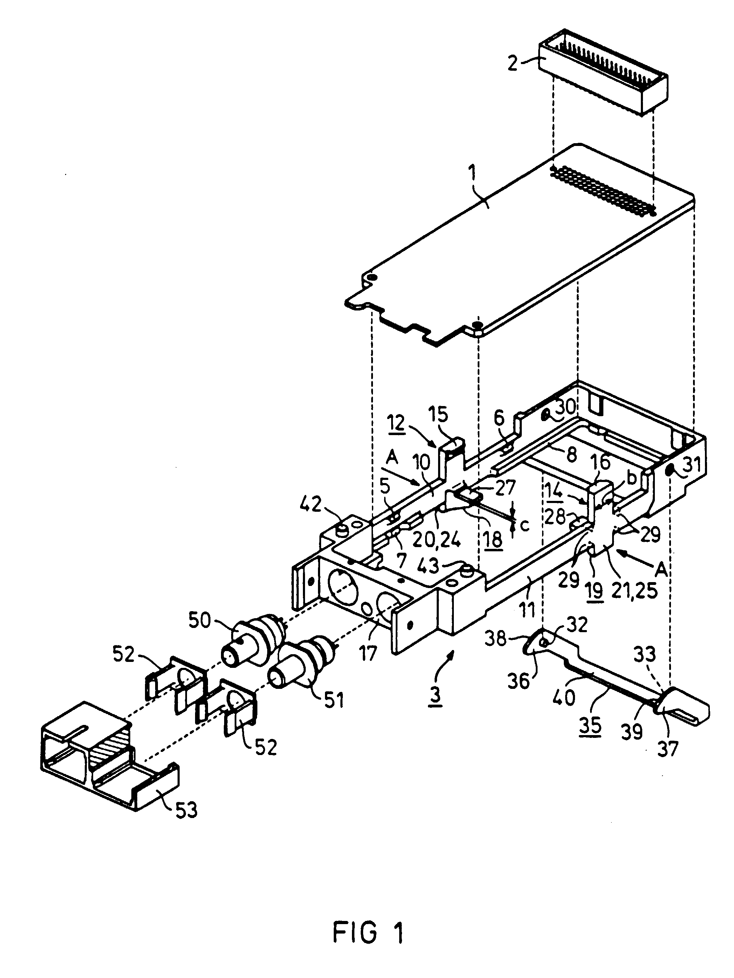

Die in Figur 1 gezeigte elektrische Baugruppe enthält eine Leiterplatte 1 mit einem 80-poligen Steckverbinder 2 und einen Rahmen 3, der Rastnasen 5, 6 und Auflagen 7, 8 aufweist.

Die Leiterplatte 1 wird in den Rahmen 3 unter leichtem Druck eingesetzt, so daß sich die gegenüberliegenden Rahmen-Langsseiten 10, 11 und/oder die Rastnasen 5, 6 leicht elastisch verformen, so daß die Leiterplatte 1 zwischen den Rastnasen 5, 6 und den Auflagen 7, 8 einrastet.

Jede Rahmen-Längsseite 10, 11 enthält einen Rastfinger 12, 14, der endseitig Rastelemente 15, 16 in Form von zum Rahmeninneren gerichteten Rasthaken aufweist. Der Rastfinger 12 ist im Vergleich zum Rastfinger 14 zumindest um den Betrag der Breite b eines Rastfingers 12, 14 näher zur Stirnseite 17 des Rahmens angeordnet, so daß die Rastfinger 12, 14 gegeneinander versetzt angeordnet sind. Die elastisch verformbaren Rastfinger 12, 14 erstrecken sich über die Rahmen-Längsseiten 10, 11 hinaus und enden in Entriegelungshebeln 18, 19. Die Entriegelungshebel 18, 19 sind im wesentlichen als gerade Prismen mit einer annähernd dreieckigen Grundfläche (dreiseitige Prismen) ausgebildet. Die jeweils seitlich vom Rahmen 3 nach außen weisenden Seiten 20, 21 der Prismen bilden Betätigungsflächen 24, 25, auf die manuell durch Fingerdruck in Richtung der Pfeile A wirkende Kräfte ausgeübt werden können. Die Betätigungsflächen können alternativ unter Verzicht auf die Entriegelungshebel 18, 19 auch auf den Außenseiten der Rahmen-Längsseiten 10, 11 liegen. Die der Leiterplatte 1 zugewandten Seiten 27, 28 der Entriegelungshebel 18, 19 verlaufen in Ruhestellung in einem vorgegebenen Abstand c annähernd parallel zur Unterseite der Leiterplatte 1. Der Abstand c ist so bemessen, daß bei ausreichender Entrastungs-Bewegung der Rastfinger 12, 14 deren Auslenkung durch Aufsetzen der Seite 27, 28 auf der Leiterplatte 1 begrenzt ist.

Der Rahmen enthält Öffnungen 30, 31, in denen Zapfen 32, 33 (Figur 1 zeigt explizit nur den Zapfen 32) eines Demontagehebels 35 gelagert sind. Der Demontagehebel 35 hat zwei Seitenteile 36, 37 mit Druckflächen 38, 39 und einen die Seitenteile 36, 37 verbindenden Bügel 40.

Im Bereich der Stirnseite 17 weist der Rahmen 3 Zapfen 42, 43 auf. Die Rahmen-Längsseiten 10, 11 können (wie beim Rastfinger 14 angedeutet) beidseitig des Rastfingers 12, 14 Einschnitte 29 aufweisen, durch die der Material-Querschnitt der jeweiligen Längsseite 10, 11 zur Erleichterung der Rastfingerbewegung vermindert ist. An dem Rahmen 3 sind stirnseitig opto-elektronische Bauelemente 50, 51 (optischer Sender und Empfänger) und Verriegelungselemente 52 mit einer Abdeckung 53 angeordnet.

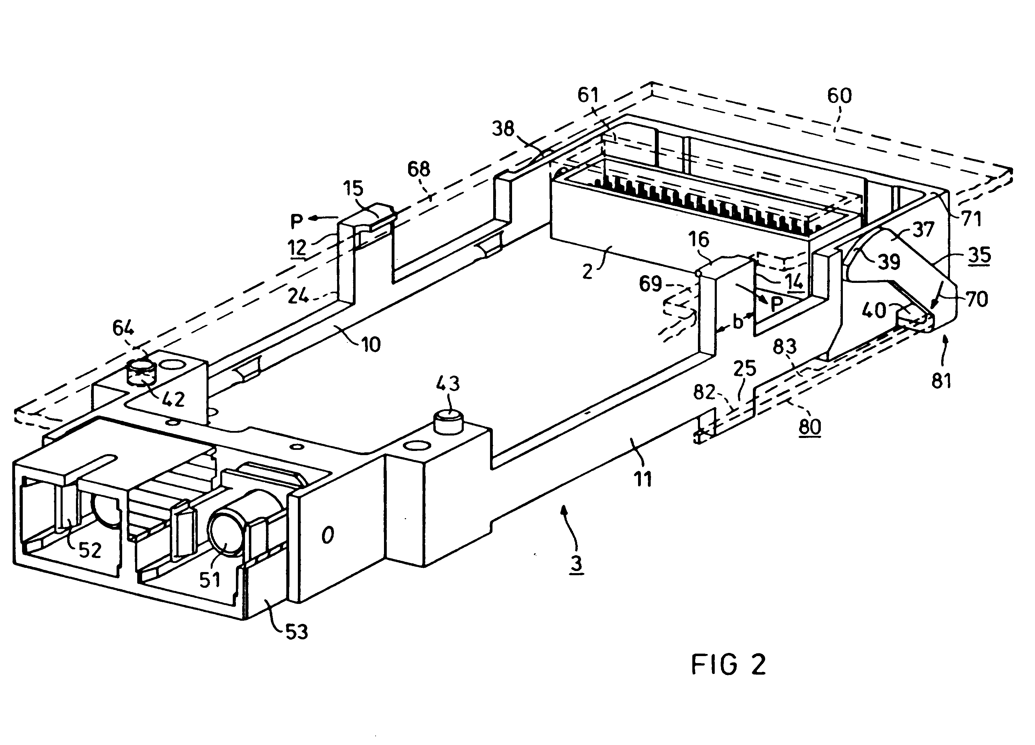

Figur 2 zeigt die ausführlich im Zusammenhang mit Figur 1 beschriebene elektrische Baugruppe im Verbindungszustand mit einer nur andeutungsweise strichliert gezeigten Hauptplatine 60. Die Hauptplatine 60 umfaßt einen zu dem mehrpoligen Steckverbinder 2 korrespondierenden (angedeuteten) Steckverbinder 61 und weist Öffnungen (Figur 2 zeigt nur eine Öffnung 64) für die Zapfen 42, 43 auf. Die Zapfen 42, 43 nehmen im Zusammenspiel mit den Öffnungen 64 in der Hauptplatine 60 beim Einführen und Ziehen von Steckelementen in die optoelektronischen Baugruppen 50, 51 auftretende Kräfte auf. Beim Verbinden der Steckverbinder 2, 61 werden die Rastfinger 12, 14 von Körperkanten 68, 69 der Hauptplatine 60 elastisch verformt. Die Körperkanten 68, 69 können Umfangskanten der Hauptplatine oder Kanten von für die Rastfinger vorgesehenen Öffnungen sein. Die Rastelemente 15, 16 können zur Erleichterung des Rastvorgangs oben leicht abgeschrägt sein. Im verbundenen Zustand hintergreifen die Rastelemente 15, 16 die Hauptplatine und verriegeln damit die Baugruppe an der Hauptplatine 60.

Um die Baugruppe aus dem verbundenen Zustand zu lösen (Demontage), kann von einer einzelnen Person mit den Fingern der einen Hand auf die Betatigungsflachen 24, 25 gedrückt werden, wodurch sich die Rastfinger 12, 14 nach außen (in Richtung der Pfeile P) bewegen, so daß die Rastelemente 15, 16 die Hauptplatine 60 freigeben und außer Eingriff zu den Körperkanten 68, 69 gebracht sind (Entrastung). Durch gleichzeitiges Bewegen des Bügels 40 in Pfeilrichtung 70 erheben sich die Druckflächen 38, 39 zumindest teilweise über die auf der Hauptplatine 60 aufliegende Oberfläche 71 des Rahmens 3 hinaus und stützen sich an der Hauptplatine 60 ab. Dadurch wird eine senkrecht zwischen Hauptplatine 60 und Baugruppe wirkende Kraft erzeugt, die die Steckverbindung entgegen den vergleichsweise hohen Verbindungskraften löst. Dadurch ist ohne zusätzliche Hilfsmittel oder Vorrichtungen ein einfaches kontrolliertes Lösen und Herausheben der Baugruppe ermöglicht, das von einer einzelnen Person bewerkstelligt werden kann.

In einer alternativen Ausgestaltung können die Rastfinger 12, 14 im Gegensatz zu dem figürlich explizit gezeigten Detail auch unmittelbar an der in den Figuren unteren Kante der Rahmen-Längsseiten 10, 11 enden, wobei auf die Entriegelungshebel 18, 19 verzichtet wird. Die Rastelemente 15, 16 können bei dieser Variante bevorzugt schräg nach vorn oben zulaufende, der Hauptplatine 60 (Figur 2) zugewandte Kontakt flächen aufweisen. Durch diese Schläge werden die Rastfinger 12, 14 allein durch das Bewegen des Bügels 40 und die damit verbundene, vorstehend beschriebene Wirkung der Druckflächen 38, 39 soweit elastisch verformt, daß sie zum Entrasten außer Eingriff mit den Körperkanten der Hauptplatine gebracht werden.

Wie sich insbesondere der Figur 2 entnehmen läßt, sind die Drehachse des Demontagehebels 35 und die Geometrie seiner Seitenteile 36, 37 mit den Druckflächen 38, 39 derart bemessen, daß die senkrecht zwischen der Hauptplatine 60 und der Baugruppe wirkenden Kräfte zur Lösung der Steckverbindung und ggf. zum Entriegeln der Rastfinger 12, 14 im wesentlichen symmetrisch und neben den Schmalseiten des Steckverbinders 2 bzw. 61 angreifen. Die durch die Bewegung des Montagehebels erzeugten Kräfte greifen dadurch unmittelbar im Bereich der Steckverbinder an, ohne den Demontagevorgang und die Baugruppe belastende außermittige Kräfte und daraus resultierende Kippmomente zu erzeugen.

In Figur 2 ist gestrichelt eine weitere Ausführungsvariante mit einem Fortsatz 80 des Demontagehebels 35 angedeutet, der mit dem Seitenteil 37 verbunden und derart ausgerichtet ist, daß beim Verschwenken des Demontagehebels aus der (in Figur 2 dargestellten) Verbindungsstellung 81 in die Demontagestellung die Schräge 82 eines verdickten Bereichs 83 auf die Betätigungsfläche 25 wirkt und somit den Rastfinger 14 in Pfeilrichtung P auffedert. Je nach konstruktiver Gestaltung des Demontagehebels 35 des Hebelwegs und der Rastfingerbreite b kann der Fortsatz 80 auch an dem Rahmen 3 geführt und drehgelenkig mit dem Seitenteil 37 verbunden sein. Das Seitenteil 36 (Figur 1) kann ebenfalls mit einem entsprechenden Fortsatz versehen sein, so daß die Bewegung des Demontagehebels 35 in die Demontagestellung gleichzeitig die Auffederung beider oder noch weiterer Rastfinger bewirkt. Durch die versetzte Anordnung der Rastfinger 12, 15 können jeweils zwei Baugruppen um 180° gedreht gegenüberliegend auf der Hauptplatine angeordnet werden.

## Patentansprüche

1. Elektrische Baugruppe
mit einer Leiterplatte (1) mit einem mehrpoligen Steckverbinder (2), der mit einem korrespondierenden Steckverbinder (61) einer Hauptplatine (60) verbindbar ist, und mit einem Demontagehebel (35) mit mindestens einer Druckfläche (37,38), der aus einer Verbindungsstellung (81) in eine
Demontagestellung verschwenkbar ist, in der sich die Druckfläche (37,38) gegen die Hauptplatine (60) abstützt und eine die Steckverbindung lösende Kraft erzeugt,
**dadurch gekennzeichnet,** daß
die Leiterplatte (1) in einen Rahmen (3) eingesetzt ist, der an gegenüberliegenden Seiten (10,11) Rastfinger (12,14) mit Rastelementen (15,16) aufweist, wobei die Rastfinger (12, 14) beim Verbinden der Steckverbinder (2,61) von Körperkanten (68,69) der Hauptplatine (60) elastisch verformbar sind und wobei die Rastelemente (15,16) im verbundenen Zustand an der Hauptplatine (60) fixierend verrasten,
und daß der Demontagehebel (35) an dem Rahmen (3) gelagert ist.

2. Baugruppe nach Anspruch 1,
**dadurch gekennzeichnet,** daß
den Rastfingern (12,14) Betatigungsflachen (24,25) zugeordnet sind, auf die manuell und/oder durch einen Fortsatz (80) des Demontagehebels (35) in der Demontagestellung die Rastelemente (15,16) entrastende Kräfte aufbringbar sind.

3. Baugruppe nach Anspruch 2,
**dadurch gekennzeichnet,** daß
die Rastfinger (12,14) Entriegelungshebel (18,19) aufweisen, die sich von den Rahmen-Längsseiten (10,11) aus und von der Leiterplatte (1) weg erstrecken und deren Außenflächen (20,21) die Betatigungsflachen (24,25) sind.

4. Baugruppe nach Anspruch 3,
**dadurch gekennzeichnet,** daß
die Entriegelungshebel (18,19) im wesentlichen als gerade, zumindest dreiseitige Prismen ausgebildet sind, deren jeweils seitlich nach außen weisende Seite (20,21) die Betätigungsfläche (24,25) bildet, und daß der Abstand (b) zwischen der jeweils der Leiterplatte (1) zugewandten Seitenfläche (27,28) und der Leiterplatte (1) gemäß der gewünschten maximalen Auslenkung der Rastfinger (12,14) bemessen ist.

5. Baugruppe nach einem der vorangehenden Ansprüche,
**dadurch gekennzeichnet,** daß
der Demontagehebel (35) an den Rahmen-Längsseiten (10,11) gelagert ist und einen sich im wesentlichen zwischen den Längsseiten (10,11) erstreckenden Bügel (40) enthält.

6. Baugruppe nach einem der vorangehenden Ansprüche,
**dadurch gekennzeichnet,** daß
die Rastfinger (12,14) einstückig mit der jeweiligen Rahmen-Langsseite (10,11) ausgebildet sind und daß der Querschnitt der Rahmen-Längsseite (10,11) beidseitig des Rastfingers (12,14) vermindert ist.

7. Baugruppe nach einem der vorangehenden Ansprüche,
**dadurch gekennzeichnet,** daß
gegenüberliegende Rastfinger (12,14) gegeneinander versetzt angeordnet sind.

## Claims

1. Electrical module having a printed circuit board (1) with a multiple plug-in connector (2) which can be connected to a corresponding plug-in connector (61) of a main board (60), and having a dismantling lever (35) with at least one thrust face (37, 38) which can be swivelled from a connecting position (81) into a dismantling position in which the thrust face (37, 38) is supported against the main board (60) and produces a force which undoes the plug-in connection, characterized in that the printed circuit board (1) is inserted into a frame (3) which, on opposite sides (10, 11), has latching fingers (12, 14) with latching elements (15, 16), the latching fingers (12, 14) being elastically formable by body edges (68, 69) of the main board (60) on connection of the plug-in connectors (2, 61), and the latching elements (15, 16) latching in a fixed fashion on the main board (60) in the connected state, and in that the dismantling lever (35) is mounted on the frame (3).

2. Module according to Claim 1, characterized in that the latching fingers (12, 14) are assigned actuating surfaces (24, 25) to which in the dismantling position it is possible to apply forces unlatching the latching elements (15, 16) manually and/or by means of an extension (80) of the dismantling lever (35).

3. Module according to Claim 2, characterized in that the latching fingers (12, 14) have unlocking levers (18, 19) which extend out from the longitudinal frame sides (10, 11) and away from the printed circuit board (1), and whose outer surfaces (20, 21) are the actuating surfaces (24, 25).

4. Module according to Claim 3, characterized in that the unlocking levers (18, 19) are essentially constructed as straight, at least three-faced prisms whose side (20, 21) respectively pointing laterally outwards forms the actuating surface (24, 25), and in that the spacing (b) between the lateral surface (27, 28) respectively facing the printed circuit board (1) and the printed circuit board (1) is dimensioned in accordance with the desired maximum deflection of the latching fingers (12, 14).

5. Module according to one of the preceding claims, characterized in that the dismantling lever (35) is mounted on the longitudinal frame sides (10, 11) and contains a link (40) extending essentially between the longitudinal sides (10, 11).

6. Module according to one of the preceding claims, characterized in that the latching fingers (12, 14) are constructed in one piece with the respective longitudinal frame side (10, 11), and in that the cross-section of the longitudinal frame side (10, 11) is reduced on both sides of the latching finger (12, 14).

7. Module according to one of the preceding claims, characterized in that opposite latching fingers (12, 14) are arranged offset relative to one another.

## Revendications

1. Module électrique
comportant une carte (1) à circuits imprimés comportant un connecteur (2) multipolaire, qui peut être relié à un connecteur (61) correspondant d'une platine (60) principale, et un levier (35) de démontage, comportant au moins une surface (37,38) de poussée, qui peut être basculé d'une position (81) de connexion à une position de démontage, dans laquelle la surface (37,38) de poussée vient porter contre la platine (60) principale et produit une force qui met fin à la liaison par enfichage caractérisé en ce que la carte (1) à circuits imprimés est disposée dans un cadre (3), qui comporte sur des côtés mutuellement opposés des doigts (12,14) d'encliquetage munis d'éléments (15,16) d'encliquetage, les doigts (12,14) d'encliquetage pouvant lors de la connection des connecteurs (2,61) être déformés élastiquement par des bords (68,69) de corps de la platine (60) principale, les éléments (15,16) d'encliquetage étant encliquetés, à l'état connecté, à la platine (60) principale en y étant immobilisés,
et en ce que le levier (35) de démontage est monté sur le cadre.

2. Module suivant la revendication 1,
caractérisé en ce qu'il est associé aux doigts (12,14) d'encliquetage des surfaces (24,25) d'actionnement, sur lesquelles des forces de désencliquetage des éléments (15,16) peuvent être appliquées, en la position démontée, manuellement ou par un prolongement (80) du levier (35) de démontage.

3. Module suivant la revendication 2,
caractérisé en ce que les doigts (12,14) d'encliquetage comportent des leviers (18,19) de déverrouillage, qui s'étendent en étant issus des grands cotés (10,11) du cadre et en s'éloignant de la carte (1) à circuits imprimés et dont les faces (20,21) extérieures constituent les surfaces (24,25) d'actionnement.

4. Module suivant la revendication 3, caractérisé en ce que les leviers (18,19) de déverrouillage sont sensiblement formés en tant que prismes droits ayant au moins trois faces, chacune de ces faces tournée vers l'extérieur latéralement formant les surfaces (24,25) d'actionnement, et en ce que la distance (b) entre les surfaces (27,28) latérales respectives tournées vers la carte (1) à circuits imprimés et la carte (1) à circuits imprimés est choisie en fonction de la déflexion maximale souhaitée des doigts (12,14) d'encliquetage.

5. Module suivant l'une des revendications précédentes caractérisé en ce que le levier (35) de démontage est monté sur les grands côtés (10,11) du cadre et comporte un étrier (40) s'étendant sensiblement entre les grands côtés (10,11).

6. Module suivant l'une des revendications précédentes, caractérisé en ce que les doigts (12,14) d'encliquetage sont formés d'une pièce avec chacun des grands côtés (10,11) du cadre et en ce que la section transversale des grands côtés (10,11) du cadre est amoindrie de part et d'autre des doigts (12,14) d'encliquetage.

7. Module suivant l'une des revendications précédentes, caractérisé en ce que des doigts (12,14) d'encliquetage se faisant face sont décalés les uns par rapport aux autres.
